# EUROPÄISCHE PATENTSCHRIFT

(11) **EP 2 430 892 B1**
(45) Veröffentlichungstag und Bekanntmachung des Hinweises auf die Patenterteilung: **20.04.2016**
(21) Anmeldenummer: 10720386.1
(22) Anmeldetag: 07.05.2010
(51) Int. Cl.: H05K 3/36

(54) **VERBINDUNG VON LEITERPLATTEN**
CONNECTION OF PRINTED CIRCUIT BOARDS
CONNEXION DE PLAQUETTES

(30) Priorität: 12.05.2009 DE 102009021730
(43) Veröffentlichungstag der Anmeldung: 21.03.2012
(73) Patentinhaber: Würth Elektronik ICS GmbH & Co. KG, 74613 Öhringen (DE)
(72) Erfinder: KALLEE, Werner, 74177 Bad Friedrichshall (DE)
(74) Vertreter: Patentanwälte Ruff, Wilhelm, Beier, Dauster & Partner mbB
(86) Internationale Anmeldenummer: PCT/EP2010/056263
(87) Internationale Veröffentlichungsnummer: WO 2010/130655

(56) Entgegenhaltungen:
- EP-A1- 1 641 081
- EP-A2- 0 825 680
- DE-A1-102004 028 202
- DE-U1- 20 218 295
- DE-U1-202004 012 466
- DE-U1-202007 013 239
- US-A1- 2001 041 467
- US-A1- 2003 092 296
- US-A1- 2004 097 141
- US-A1- 2007 087 592

## Beschreibung

Die Erfindung betrifft eine Anordnung zur Verbindung von Leiterplatten.

Es ist bekannt, dass in elektrischen oder elektronischen Geräten auch mehrere Leiterplatten angeordnet sein können, die funktionsmäßig miteinander verbunden werden müssen. Dies kann beispielsweise dadurch geschehen, dass die Leiterplatten in einem Rahmen angeordnet werden, der auch elektrische Verbindungen aufnimmt, so dass mehrere Leiterplatten über den Rahmen auch elektrisch miteinander verbunden werden.

Es ist aber auch schon bekannt, zwei Leiterplatten parallel zueinander direkt miteinander zu verbinden. Hierzu sind auch Steckverbindungen bekannt.

Bei einer derartigen Verbindungsanordnung zweier Leiterplatten mithilfe von Steckeinrichtungen weist die Steckverbindung zwei identisch ausgebildete Teile auf, von denen jedes Teil ein Gehäuse und Steckerstifte und Steckbuchsen enthält. Jedes der beiden Elemente wird mit einer der beiden zu verbindenden Leiterplatten verbunden, und zwar in SMT Technologie. Dann können die beiden Leiterplatten durch Stecken miteinander verbunden werden, wobei die Steckerstifte beider Hälften der Steckverbindung in die Steckbuchsen der jeweils anderen Hälfte eingreifen. Diese Verbindung ist auch lösbar (US 5498167).

Bei einer ähnlichen Anordnung weist die Steckverbindung ebenfalls zwei Teile auf, von denen ein Teil ein Gehäuse und Steckerstifte und das andere Teil ein Gehäuse und Steckbuchsen aufweist. Jedes Teil wird in SMT Technologie mit einer der beiden Leiterplatten verbunden, und dann können die Leiterplatten durch Eingreifen der Steckerstifte in die Steckbuchsen miteinander verbunden werden. Auch hierbei werden zwei Gehäuseteile benötigt (EP 835538 B1).

**Weiterhin ist ein Leiterplattenverbinder bekannt, bei dem in einem Isolierkörper eine Vielzahl von Einpressstiften eingesetzt sind, die beidseitig mit identischen Kontaktanschlüssen aus dem Isolierkörper hervor stehen. Die Einpressstifte können nur von einer Seite aus eingeschoben werden und auch nur aus dieser Seite herausgezogen werden (**DE 202007 013239 U1**).**

**Zur Verbindung von Leiterplatten ist weiterhin ein elektrisches Verbindungselement bekannt, das an seinen beiden enden unterschiedlich breite Kontaktelemente aufweist. Das Verbindungselement soll mit dem schmaleren Kontaktelement durch die für das andere Kontaktelement bestimmte Öffnung hindurchgeschoben werden, ohne dort hängen zu bleiben (**EP 0825680 A2**).**

**Weiterhin ist es bekannt, Leiterplatten mithilfe von Kontaktelementen zu verbinden, die U-förmig ausgebildet sind und unterschiedlich lange Schenkel aufweisen. Diese Kontaktelemente können nicht zwischen den Leiterplatten angeordnet werden (**EP 1641081 A1**).**

**Ebenfalls bekannt ist ein Kontaktelement für Leiterplatten, das zwei Schenkel mit abgerundeten Außenseiten aufweist. Die Enden der Schenkel weisen einander zugewandten Anlageflächen auf (**DE 20218295 U1**).**

Der Erfindung liegt die Aufgabe zu Grunde, eine mit geringem Aufwand durchzuführende Möglichkeit zu schaffen, Leiterplatten direkt miteinander zu verbinden.

Zur Lösung dieser Aufgabe schlägt die Erfindung eine Verbindungsanordnung mit den Merkmalen des Anspruchs 1 vor. Weiterbildungen der Erfindung sind Gegenstand von Unteransprüchen.

Die Verbindungsanordnung enthält also mindestens ein einstückiges Verbindungselement, dessen beide durch das Mittelteil verbundene Enden jeweils als Kontaktelement ausgebildet sind. Dadurch kann das Verbindungselement im Bereich beider Enden in eine durchkontaktierte Bohrung der jeweiligen Leiterplatte eingesteckt werden. In dieser durchkontaktierten Bohrung liegt das Verbindungselement durch Klemmung fest.

Es ist weder eine Festlegung eines Verbindungselements durch SMT Technologie noch die Verwendung immer zweier Verbindungselemente zur Herstellung einer leitenden Verbindung erforderlich.

In Weiterbildung der Erfindung **ist** vorgesehen, dass das Verbindungselement in einem Isolierkörper angeordnet ist, und zwar in einer solchen Weise, dass die an beiden Enden des Mittelteils ausgebildeten Kontaktelemente jeweils aus einer anderen Stirnfläche des Isolierkörpers herausragen.

Insbesondere dann, wenn mehrere Verbindungselemente vorhanden sind, dient der Isolierkörper dazu, die mehreren Verbindungselemente zusammenzufassen und zu haltern, so dass sich die Anordnung leichter handhaben lässt.

In nochmaliger Weiterbildung der Erfindung kann vorgesehen sein, dass die Stirnseiten des Isolierkörpers, aus dem die Kontaktelemente herausragen, Anlageflächen für die miteinander zu verbindenden Leiterplatten bilden. Dies führt dazu, dass das Verbindungselement in die Bohrung der Leiterplatte eingeschoben wird, bis die Leiterplatte an der Stirnfläche des Isolierkörpers anliegt. Dies begrenzt gleichzeitig die Eindringtiefe der Kontaktelemente in die Bohrung der Leiterplatte. Auf diese Weise kann dafür gesorgt werden, dass das Kontaktelement in der richtigen räumlichen Zuordnung zu der Leiterplatte angeordnet wird.

Gleichzeitig bildet der Isolierkörper dadurch ein Abstandselement zur Festlegung des Abstands zwischen den beiden Leiterplatten. Im Unterschied zum Stand der Technik ist aber nur ein einziger Isolierkörper erforderlich, der zudem noch einfacher aufgebaut sein kann als die Isolierkörper im Stand der Technik.

In Weiterbildung der Erfindung **ist** vorgesehen, dass das Verbindungselement in dem Isolierkörper gegen ein Herausziehen gesichert ist, damit aber auch gegen ein Herausschieben, und zwar in beide Richtungen. Es wird auf diese Weise möglich, das Einstecken der Verbindungselemente dadurch durchzuführen, dass an dem Isolierkörper angegriffen wird und nicht an dem Verbindungselement selbst. Selbstverständlich ist es auch möglich, an dem Isolierkörper anzugreifen, wenn eine Verbindung wieder gelöst werden soll.

Die Möglichkeit, die Verbindung als eine mehrfach durchzuführende lösbare Verbindung zu gestalten, wird durch die Auswahl der Klemmkraft bestimmt, die dem Kontaktelement an beiden Seiten des Verbindungselements mitgegeben wird.

Insbesondere kann in Weiterbildung vorgesehen sein, dass das Verbindungselement in dem Isolierkörper unverschiebbar gehaltert ist.

In Weiterbildung der Erfindung **ist** vorgesehen, dass die Klemmkraft, mit dem die beiden Kontaktelemente des Verbindungselements in der jeweiligen Bohrung angreifen, unterschiedlich groß ist. Da die durchkontaktierten Bohrungen der Leiterplatten üblicherweise gleich groß sein sollen, kann die unterschiedliche Klemmkraft durch Gestaltung der Kontaktelemente selbst bewirkt werden.

Die Verbindungsanordnung zwischen zwei Leiterplatten kann unter Umständen so angeordnet sein kann, dass zum Lösen einer Verbindung nicht an dem Isolierkörper selbst angegriffen werden kann, sondern nur an der Leiterplatte selbst. Wäre die Klemmkraft an beiden Kontaktelementen eines Verbindungselements gleich groß, so ließe sich nicht voraussagen, an welcher Seite das Kontaktelement zu erst aus dem Loch herausgezogen wird. Bei Verwendung eines Isolierkörpers mit einer größeren Zahl von Verbindungselementen könnte sich der Isolierkörper verkanten und dadurch die Einrichtung beschädigt werden. Wenn dafür gesorgt ist, dass die Klemmkraft an dem einen Ende des Verbindungselements größer ist als an dem anderen, und wenn alle Verbindungselemente in der gleichen Orientierung angeordnet sind, ist dafür gesorgt, dass die Verbindungsanordnung sich zunächst von der einen Leiterplatte löst und an der anderen Leiterplatte stecken bleibt.

Es gibt eine Vielzahl von Möglichkeiten, wie diese unterschiedlich große Klemmkraft bewirkt werden kann. Beispielsweise kann das Kontaktelement an dem einen Ende anders konstruiert sein als das Kontaktelement an dem anderen Ende.

In Weiterbildung der Erfindung kann vorgesehen sein, dass mindestens ein Kontaktelement eines Verbindungselements zwei oder mehr durch einen in Steckrichtung verlaufenden Schlitz getrennte Kontaktzungen aufweist. Die Klemmkraft wird dadurch erzeugt, dass die Kontaktzungen nach innen gedrückt werden, wodurch sie eine Gegenkraft erzeugen.

Die Dicke der Kontaktzungen quer zur Richtung des Schlitzes kann dazu herangezogen werden, die Gegenkraft und damit die Klemmkraft zu beeinflussen. Um eine unterschiedliche Klemmkraft an beiden Enden des Verbindungselements herzustellen, kann beispielsweise die Dicke der Kontaktzungen an dem einen Ende größer sein als die Dicke der Kontaktzungen an dem anderen Ende des Verbindungselements.

Eine andere Möglichkeit besteht darin, dass die Zahl der Kontaktzungen an den beiden Enden des Verbindungselements unterschiedlich groß ist.

Eine weitere Möglichkeit zur Beeinflussung der Klemmkraft besteht darin, die Kontaktzungen unterschiedliche lange zu gestalten oder anders ausgedrückt den Schlitz zwischen den Kontaktzungen an beiden Enden des Verbindungselements unterschiedlich lang zu machen.

Erfindungsgemäß kann in Weiterbildung der Erfindung vorgesehen sein, dass die Länge des Schlitzes zwischen den Kontaktzungen größer ist als der Teil der Kontaktzungen, der aus der entsprechenden Stirnseite des Isolierkörpers herausragt.

Die Verbindungsanordnung nach der Erfindung kann auch dazu verwendet werden, eine Verbindung zu schaffen, die nur an der einen Seite des Isolierkörpers lösbar ist, während sie an der anderen Seite fest ist. So kann beispielsweise das Kontaktelement an dem einen Ende des Verbindungselements als zum Einpressen geeigneter Kontaktstift ausgebildet sein. Hier werden dann die Verbindungselemente in die durchkontaktierten Bohrungen einer Leiterplatte eingepresst, so dass sie dort fest bleiben und sich nicht mehr zerstörungsfrei lösen lassen. An der anderen Seite kann dann eine lösbare Steckverbindung vorhanden sein. Auf diese Weise lässt sich eine Art Steckerleiste dauerhaft mit einer Leiterplatte verbinden.

In nochmaliger Weiterbildung der Erfindung kann vorgesehen sein, dass die Sicherung des Verbindungselements in dem Isolierkörper gegen sein Herausziehen in dem Bereich des Verbindungselements geschieht, wo der Schlitz zwischen den Kontaktzungen vorhanden ist. Die Nachgiebigkeit der Kontaktzungen, die durch den Längsschlitz ermöglicht wird, kann dann auch dazu herangezogen werden, das Verbindungselement in den Isolierkörper einzuschieben.

Vorzugsweise ist das Verbindungselement in einem Durchgang des Isolierkörpers angeordnet, der sich von der einen Stirnseite zu der anderen Stirnseite des Isolierkörpers erstreckt.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: einen Ausschnitt aus einem Stanzteil zur Herstellung von Verbindungselementen;
- Figur 2: eine abgebrochene Seitenansicht der Anordnung der Figur 1;
- Figur 3: eine Draufsicht auf einen Isolierkörper zur Aufnahme der Verbindungselemente;
- Figur 4: einen teilweise im Längsschnitt durch den Isolierkörper der Figur 3 längs Linie IV-IV;
- Figur 5: einen Querschnitt durch den Isolierkörper längs Linie V-V in Figur 3.

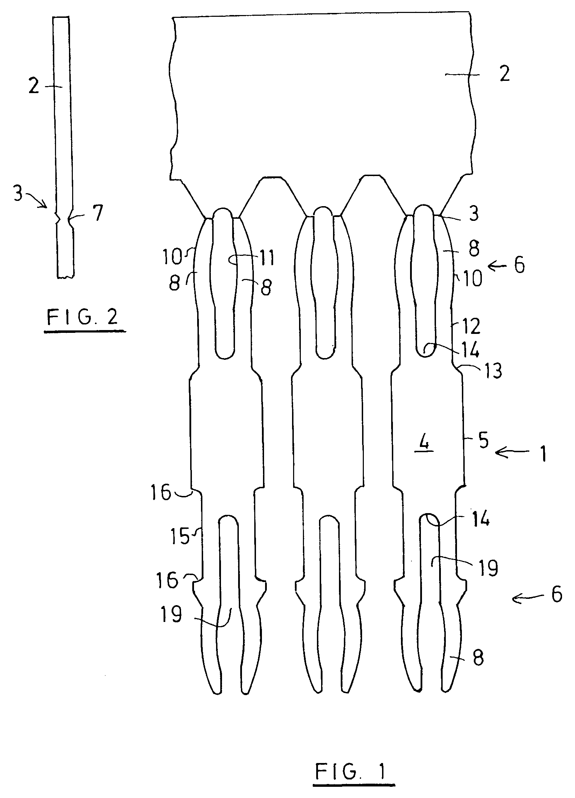

Die von der Erfindung vorgeschlagene Verbindungsanordnung zur elektrischen und mechanischen Verbindung zweier Leiterplatten miteinander enthält ein Verbindungselement 1, das aus einem Stück Blech ausgestanzt wird. Die Figur 1 zeigt einen Ausschnitt aus einem schon gestanzten Blech. An einem noch vorhandenen Blechstreifen 2 hängen über eine Sollbruchstelle 3 noch verbunden die einzelnen Verbindungselemente 1.

Jedes Verbindungselement 1 enthält einen Mittelteil vier, das von zwei Parallelen Seitenkanten 5 begrenzt wird. An jedem Ende des Mittelteils 4 ist das Verbindungselement als Kontaktelement 6 ausgebildet. Dies gilt sowohl für das in Figur 1 obere Ende des Verbindungselements 1, an dem das Verbindungselement noch mit dem Blechstreifen 2 verbunden ist, als auch für das gegenüberliegende freie Ende, das in Figur 1 unten dargestellt ist.

Wie man der Figur 2 entnehmen kann, ist die Sollbruchstelle 3 durch eine Kerbe 7 an beiden Flachseiten des Blechstreifens gebildet.

Im dargestellten Beispiel enthält jedes Kontaktelement 6 zwei Kontaktzungen 8, zwischen denen ein Längsschlitz 9, 19 gebildet ist. Der Längsschlitz 9, 19 ist zum jeweiligen freien Ende des Kontaktelements 6 hin offen. Die nach außen gerichtete Außenkante 10 der Kontaktzungen 8 ist leicht konvex ausgebildet, ebenso die zum Schlitz 9,19 hin gerichtete Innenkante 11 der Kontaktzungen.

Die Außenkante 12 der Kontaktzungen 8 ist in dem sich an dem Mittelteil anschließenden Bereich geradlinig ausgebildet. Zwischen der Außenkante 5 des Mittelteils 4 und dem geradlinigen Abschnitt 12 der Außenkante der Kontaktzungen 8 ist ein schräger Übergang 13 gebildet. Das Ende des zur Außenseite hin offenen Schlitzes neun ist durch einen Bogen 14 abgerundet. Der gleiche Bogen 14 ist auch an dem Ende des anderen Längsschlitzes 19 vorhanden.

Das Kontaktelement 6 an dem gegenüberliegenden, in Figur 1 unteren Ende des Mittelteils 4 ist ähnlich aufgebaut wie das Kontaktelement 6 am anderen Ende, jedoch ist der hier vorhandene Längsschlitz 19 länger. In dem Übergangsbereich zwischen dem Mittelteil 4 und den Kontaktzungen 8 ist an der Außenseite eine Ausnehmung 15 gebildet, die beidseits von einem abgerundeten stufenartigen Übergang 16 begrenzt ist. Dieser stufenartige Übergang 16 bildet eine angenähert quer zur Längsachse des Verbindungselements 1 verlaufende Anschlagstufe. Der Längsschlitz 19 reicht bis weit in den Bereich dieser Ausnehmung 15 hinein.

Aufgrund der größeren Länge des Längsschlitzes 19 an dem Kontaktelement 6 im unteren Bereich gegenüber dem Längsschlitz 9 des Kontaktelements 6 am oberen Ende des Verbindungselements 11 gibt bei sonst gleicher Dicke der Kontaktzungen 8 das untere Kontaktelement 6 leichter nach. Es entwickelt also dann, wenn man es in eine Öffnung steckt, eine geringere Klemmkraft als das Kontaktelement 6 am anderen Ende.

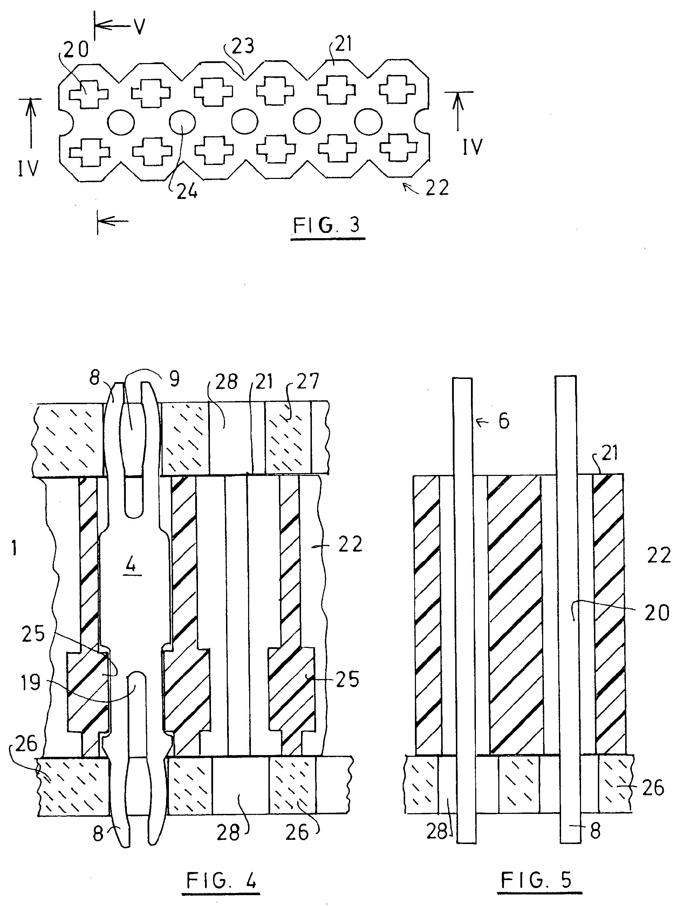

Die Figur 3, auf die jetzt Bezug genommen wird, zeigt einen Isolierkörper 22, der zur Aufnahme und Halterung einer Vielzahl von Verbindungselementen 1 ausgebildet und bestimmt ist. Der Isolierkörper weist paarweise Durchgänge 20 auf, die von der einen in Figur 3 sichtbaren Stirnfläche 21 des Isolierkörpers 22 zu der anderen Stirnfläche hindurch gehen. Zwischen jedem Paar von Durchgängen 20 ist die Breite des Isolierkörpers 22 durch Kerben 23 verringert. An der gleichen Stelle zwischen zwei Kerben 23 und damit auch zwischen zwei benachbarten Paaren von Durchgängen 20 ist ein kreisrunder Durchgang 24 vorhanden. Auf diese Weise lässt sich der Isolierkörper leicht ablängen. Er kann beispielsweise in großen Längen hergestellt werden und dann auf die jeweilige erforderliche Länge verkürzt werden.

Jeder Durchgang 20 weist die Querschnittsform eines Kreuzes auf, wobei die in Längsrichtung des Isolierkörpers 22 verlaufenden Balken des Kreuzes zur Aufnahme jeweils eines Verbindungselements 1 bestimmt sind. In der dargestellten Ausführungsform des Isolierkörpers sind damit also zwei Reihen von Durchgängen 20 für Verbindungselemente vorhanden. Selbstverständlich könnten auch mehr als zwei Reihen vorhanden sein. Dies hängt von den Umständen des Einzelfalls ab.

In diese Durchgänge 20 wird dann jeweils, wie bereits erwähnt, ein Verbindungselement 1 eingeschoben. Das Ergebnis ist in Figur 4 dargestellt, die einen Längsschnitt durch den Isolierkörper der Figur 3 darstellt. Der Durchgang 20 weist in seinem einen Endbereich einen nach innen gerichteten Vorsprung 25 auf, dessen axiale Länge zwischen den beiden Stirnseiten 21 des Isolierkörpers 22 der in gleicher Richtung gemessenen Länge der Ausnehmung 15 der Verbindungselemente 1 entspricht. Das Verbindungselement 1 wird in Figur 4 von oben her in den Isolierkörper 22 eingeschoben, wobei aufgrund des längeren Längsschlitzes 19 im unteren Bereich die Kontaktzungen 8 nach innen federn und nachgeben. Dadurch gelangt der Vorsprung 26 an der Außenseite der Kontaktzungen 8 an dem nach innen gerichteten Vorsprung 25 des Isolierkörpers 22 wobei, bis er die in Figur 4 dargestellte Position einnimmt. Dann liegt der Vorsprung 25 in der Ausnehmung 15. Das Verbindungselement 1 ist nun in beide Richtungen gegen Herausziehen aus dem Isolierkörper 22 gesichert.

Aus beiden Stirnflächen 21 des Isolierkörpers 22 ragen die Kontaktzungen 8 heraus. Die Länge der Schlitze 9, 19 ist größer als der aus dem Isolierkörper 22 herausragende Teil der Kontaktzungen 8.

Sobald in den Isolierkörper 22 alle Verbindungselemente 1 angeordnet sind, kann die Verbindung mit zwei Leiterplatten 26, 27 erfolgen. Beispielsweise wird der Isolierkörper auf die untere Leiterplatte 26 den darin enthaltenen durchkontaktierten Bohrungen 28 gegenüber ausgerichtet aufgesetzt, wobei die Kontaktzungen 8 in diese durchkontaktierten Bohrungen 28 eingeschoben werden. Sie liegen an der Wand der Bohrungen 28 dann mit einer gewissen Klemmkraft an.

Anschließend wird die obere Leiterplatte 27 auf die aus der oberen Stirnseite 21 herausragenden Kontaktelemente 6 aufgeschoben, bis auch diese Leiterplatte 27 an der entsprechenden Stirnfläche 21 des Isolierkörpers 22 anliegt. Damit ist dann eine mechanische und elektrische Verbindung zwischen den beiden Leiterplatten 26, 27 hergestellt. Die beiden Leiterplatten sind parallel zueinander angeordnet, wobei ihr gegenseitiger Abstand durch die Dicke des Isolierkörpers 22 bestimmt ist. Die Festlegung der Verbindungselemente 1 in den Isolierkörper 22 bestimmt auch, wie weit die Kontaktelemente 6 in die Bohrungen 28 der Leiterplatten 26,27 eingreifen.

Die Figur 5 zeigt einen Querschnitt durch die Anordnung der Figur 4, wobei in diesem Fall die obere Leiterplatte 27 weggelassen ist.

Im dargestellten Beispiel ist die Verbindungsanordnung so entworfen, dass sie von beiden Leiterplatten 26, 27 wieder gelöst werden kann. Wenn man die beiden Leiterplatten 26, 27 auseinander zieht, löst sich zuerst die Verbindung zwischen den Verbindungselementen 1 und der unteren Leiterplatte 26, da dort der längere Längsschlitz 19 vorhanden ist.

Die Art der Ausbildung der Kontaktelemente 6 mit zwei Kontaktzungen 8, die durch einen einseitig offenen Längsschlitz 9 beziehungsweise 19 voneinander getrennt sind, ist eine der Möglichkeiten, wie die Kontaktelemente ausgebildet sein können. Es ist auch denkbar, die Kontaktzungen an ihrem Endbereich miteinander zu verbinden, so dass der Längsschlitz 9 beziehungsweise 19 beidseits begrenzt ist.

Weitere Arten der Ausbildung von lösbaren Kontaktelementen sind im Stand der Technik bekannt.

Es ist auch denkbar, dass man das Kontaktelement eines Verbindungselements an einer Seite als festen Kontaktstift ausbildet, so dass der Isolierkörper mit den darin enthaltenen Verbindungselementen an seiner einen Stirnseite mit einer Leiterplatte dauerhaft verpresst wird.

## Patentansprüche

1. Anordnung zur elektrischen und mechanischen Verbindung zweier Leiterplatten (26, 27) miteinander, enthaltend
mindestens ein einstückiges Verbindungselement (1), das
ein Mittelteil (4) und
an beiden Enden je ein Kontaktelement (6) aufweist, das
zum Einstecken in eine durchkontaktierte Bohrung (28) jeweils einer der beiden zu verbindenden Leiterplatten (26, 27) ausgebildet ist,
in der es durch Klemmung quer zur Einsteckrichtung festlegbar ist, wobei
das Verbindungselement (1) in einem zwei voneinander abgewandte Stirnseiten (21) aufweisenden Isolierkörper (22) angeordnet ist, aus dessen Stirnseiten (21) jeweils ein Kontaktelement (6) herausragt,
**dadurch gekennzeichnet, dass**
das Verbindungselement (1) in dem Isolierkörper (22) gegen Herausziehen in beide Richtungen gesichert ist und
die Klemmkraft der beiden Kontaktelemente (6) des Verbindungselements (1) unterschiedlich groß ist.

2. Anordnung nach Anspruch 1, bei der die Stirnseiten (21) des Isolierkörpers (22) Anlageflächen für die miteinander zu verbindenden Leiterplatten (26, 27) bilden.

3. Anordnung nach Anspruch 1 oder 2, bei der das Verbindungselement (1) in dem Isolierkörper (22) unverschiebbar gehaltert ist.

4. Anordnung nach einem der vorhergehenden Ansprüche, bei der das Verbindungselement (1) in einem sich zwischen den beiden Stirnseiten (21) des Isolierkörpers (22) erstreckenden Durchgang (20) angeordnet ist.

5. Anordnung nach einem der vorhergehenden Ansprüche, bei der mindestens ein Kontaktelement (6) mindestens zwei durch einen in axialer Richtung verlaufenden Schlitz (9, 19) getrennte Kontaktzungen (8) aufweist.

6. Anordnung nach Anspruch 5, bei der die Dicke der Kontaktzungen (8) des Kontaktelements (6) an dem einen Ende des Verbindungselements (1) sich von der Dicke der Kontaktzungen (8) an dem anderen Ende des Verbindungselements (1) unterscheidet.

7. Anordnung nach Anspruch 5 oder 6, bei der die Zahl der Kontaktzungen (8) des Kontaktelements (6) an dem einen Ende des Verbindungselements (1) sich von der Zahl der Kontaktzungen (8) des Kontaktelements (6) an dem anderen Ende des Verbindungselements (1) unterscheidet.

8. Anordnung nach einem der Ansprüche 5 bis 7, bei der die Länge des Schlitzes (9, 19) zwischen den Kontaktzungen (8) beziehungsweise die Länge der Kontaktzungen (8) des Kontaktelements (6) an dem einen Ende des Verbindungselements (1) sich von der Länge des Schlitzes (9, 19) der Kontaktzungen (8) an dem anderen Ende des Verbindungselements (1) unterscheidet.

9. Anordnung nach einem der Ansprüche 5 bis 8, bei der die Länge des Schlitzes (9, 19) mindestens eines Kontaktelements (6) größer ist als der aus dem Isolierkörper (22) herausragende Teil der Kontaktzungen (8).

10. Anordnung nach einem der vorhergehenden Ansprüche, bei der mindestens ein Kontaktelement (6) des Verbindungselements (1) als in eine durchkontaktierte Bohrung (28) der Leiterplatte (26, 27) einpressbarer Kontaktstift ausgebildet ist.

11. Anordnung nach einem der vorhergehenden Ansprüche, bei der die Sicherung des Verbindungselements (1) gegen Herausziehen im Bereich eines Längsschlitzes (19) zwischen mindestens zwei Kontaktzungen (8) erfolgt.

12. Anordnung nach einem der vorhergehenden Ansprüche, mit einer Vielzahl von insbesondere identisch ausgebildeten Verbindungselementen (1).

13. Anordnung nach einem der vorhergehenden Ansprüche, bei der das Verbindungselement (1) aus Blech ausgestanzt ist.

## Claims

1. An arrangement for electrically and mechanically connecting two circuit boards (26, 27) to one another, containing
at least one integral connecting element (1) which has
a central part (4) and
in each case one contact element (6) at the two ends, which contact element
is designed to be inserted into a plated-through hole (28) in in each case one of the two circuit boards (26, 27) which are to be connected,
in which plated-through hole said connecting element can be fixed transverse to the insertion direction by clamping, wherein
the connecting element (1) is arranged in an insulating body (22) which has two end faces (21) which are averted from one another, in each case one contact element (6) projecting out of the end faces (21) of said insulating body,
**characterized in that**
the connecting element (1) is secured against being pulled out in both directions in the insulating body (22), and
the clamping force of the two contact elements (6) of the connecting element (1) has a different magnitude.

2. The arrangement according to claim 1, wherein the end faces (21) of the insulating body (22) form abutment surfaces for the circuit boards (26, 27), which are to be connected to one another.

3. The arrangement according to claim 1 or 2, wherein the connecting element (1) is held in a non-displaceable manner in the insulating body (22).

4. The arrangement according to any one of the preceding claims, wherein the connecting element (1) is arranged in a passage (20) which extends between the two end faces (21) of the insulating body (22).

5. The arrangement according to any one of the preceding claims, wherein at least one contact element (6) has at least two contact tongues (8) which are separated by a slot (9, 19) which runs in the axial direction.

6. The arrangement according to claim 5, wherein the thickness of the contact tongues (8) of the contact element (6) at one end of the connecting element (1) differs from the thickness of the contact tongues (8) at the other end of the connecting element (1).

7. The arrangement according to claim 5 or 6, wherein the number of contact tongues (8) of the contact element (6) at one end of the connecting element (1) differs from the number of contact tongues (8) of the contact element (6) at the other end of the connecting element (1).

8. The arrangement according to any one of claims 5 to 7, wherein the length of the slot (9, 19) between the contact tongues (8) or the length of the contact tongues (8) of the contact element (6) at one end of the connecting element (1) differs from the length of the slot (9, 19) of the contact tongues (8) at the other end of the connecting element (1).

9. The arrangement according to any one of claims 5 to 8, wherein the length of the slot (9, 19) in at least one contact element (6) is greater than the part of the contact tongues (8) which projects from the insulating body (22).

10. The arrangement according to any one of the preceding claims, wherein at least one contact element (6) of the connecting element (1) is in the form of a contact pin which can be pressed into a plated-through hole (28) in the circuit board (26, 27).

11. The arrangement according to any one of the preceding claims, wherein the connecting element (1) is secured against being pulled out in the region of a longitudinal slot (19) between at least two contact tongues (8).

12. The arrangement according to any one of the preceding claims having a plurality of, in particular identical, connecting elements (1).

13. The arrangement according to any one of the preceding claims, wherein the connecting element (1) is stamped out of sheet metal.

## Revendications

1. Arrangement de liaison électrique et mécanique de deux circuits imprimés (26, 27) l'un à l'autre, comprenant
au moins un élément de liaison (1) monobloc qui possède une partie centrale (4) et
respectivement un élément de contact (6) aux deux extrémités, lequel
est configuré pour être inséré dans un orifice de contact traversant (28) respectivement de l'un des deux circuits imprimés (26, 27) à relier,
dans lequel il peut être immobilisé par serrage transversalement au sens de l'insertion
l'élément de liaison (1) étant disposé dans un corps isolant (22) possédant deux côtés frontaux (21) opposés l'un à l'autre et des côtés frontaux (21) duquel fait respectivement saillie un élément de contact (6) **caractérisé en ce que**
l'élément de liaison (1) est bloqué dans le corps isolant (22) contre une extraction dans les deux directions et
la force de serrage des deux éléments de contact (6) de l'élément de liaison (1) est différente.

2. Arrangement selon la revendication 1, avec lequel les côtés frontaux (21) du corps isolant (22) forment des surfaces d'appui pour les circuits imprimés (26, 27) à relier l'un à l'autre.

3. Arrangement selon la revendication 1 ou 2, avec lequel l'élément de liaison (1) est maintenu dans le corps isolant (22) de manière à ne pas pouvoir coulisser.

4. Arrangement selon l'une des revendications précédentes, avec lequel l'élément de liaison (1) est disposé dans un passage (20) qui s'étend entre les deux côtés frontaux (21) du corps isolant (22).

5. Arrangement selon l'une des revendications précédentes, avec lequel au moins un élément de contact (6) possède au moins deux languettes de contact (8) séparées par une fente (9, 19) qui s'étend dans la direction axiale.

6. Arrangement selon la revendication 5, avec lequel l'épaisseur des languettes de contact (8) de l'élément de contact (6) à l'une des extrémités de l'élément de liaison (1) est différente de l'épaisseur des languettes de contact (8) à l'autre extrémité de l'élément de liaison (1).

7. Arrangement selon la revendication 5 ou 6, avec lequel le nombre de languettes de contact (8) de l'élément de contact (6) à l'une des extrémités de l'élément de liaison (1) est différent du nombre de languettes de contact (8) de l'élément de contact (6) à l'autre extrémité de l'élément de liaison (1).

8. Arrangement selon l'une des revendications 5 à 7, avec lequel la longueur de la fente (9, 19) entre les languettes de contact (8) ou la longueur des languettes de contact (8) de l'élément de contact (6) à l'une des extrémités de l'élément de liaison (1) est différente de la longueur de la fente (9, 19) des languettes de contact (8) à l'autre extrémité de l'élément de liaison (1).

9. Arrangement selon l'une des revendications 5 à 8, avec lequel la longueur de la fente (9, 19) d'au moins un élément de contact (6) est plus grande que celle de la partie des languettes de contact (8) qui fait saillie hors du corps isolant (22).

10. Arrangement selon l'une des revendications précédentes, avec lequel l'au moins un élément de contact (6) de l'élément de liaison (1) est réalisé sous la forme d'une broche de contact qui peut être enfoncée dans un orifice de contact traversant (28) du circuit imprimé (26, 27).

11. Arrangement selon l'une des revendications précédentes, avec lequel le blocage de l'élément de liaison (1) contre une extraction s'effectue dans la zone d'une fente longitudinale (19) entre au moins deux languettes de contact (8).

12. Arrangement selon l'une des revendications précédentes, comprenant une pluralité d'éléments de liaison (1), notamment de configuration identique.

13. Arrangement selon l'une des revendications précédentes, avec lequel l'élément de liaison (1) est découpé à la matrice dans une tôle.
